(19) Europäisches Patentamt
European Patent Office
Office européen des brevets

(11) **EP 4 336 727 A1**

(12) **EUROPEAN PATENT APPLICATION**

(43) Date of publication:
**13.03.2024 Bulletin 2024/11**

(21) Application number: **23190279.2**

(22) Date of filing: **08.08.2023**

(51) International Patent Classification (IPC):
**H03F 1/02** (2006.01)   **G05F 1/575** (2006.01)
**H02M 1/00** (2006.01)   **H03F 3/183** (2006.01)
**H03F 3/45** (2006.01)

(52) Cooperative Patent Classification (CPC):
**H03F 3/183; G05F 1/575; H02M 1/00;
H03F 1/0222; H03F 3/45089**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **09.09.2022 US 202217930922**

(71) Applicant: **Harman International Industries,
Incorporated
Stamford, CT 06901 (US)**

(72) Inventors:
• PAN, Zhongfeng
 **Shanghai 200135 (CN)**
• XIA, Qingfeng
 **Kun Shan 200136 (CN)**
• ZHOU, Qiang
 **Shanghai 201111 (CN)**
• LU, Wei Jia
 **Shanghai 201203 (CN)**

(74) Representative: **Rummler, Felix
Maucher Jenkins
Liebigstrasse 39
80538 München (DE)**

(54) **SYSTEM AND METHOD FOR ADAPTIVE VOLTAGE CONTROL LOOP COMPENSATION FOR TRACKING POWER SUPPLY APPLICATIONS**

(57)   Embodiments are disclosed for a compensating circuit for a boost circuit that outputs a voltage that is a function of a voltage signal. In one or more examples, the compensation circuit may include a gain that is adjustable in proportion to voltage output of the boost circuit and inversely proportionate to input current to the boost circuit.

FIG. 1

**Description**

FIELD

This disclosure relates to providing compensation for a tracking power supply.

BACKGROUND

An infotainment system of a vehicle may include a power amplifier that operates at a voltage that is greater than the vehicle's battery voltage. The voltage that is greater than battery voltage may be generated by a boost circuit. The voltage level that is greater than battery voltage may be adjusted to make the power amplifier more efficient. One way to adjust the voltage level may be to adjust the voltage level based on amplitude of an audio signal (e.g., a tracking signal). For example, if the amplitude of the tracking signal increases, the voltage that is provided to the power amplifier is increased. Conversely, if the amplitude of the tracking signal decreases, the voltage that is provided to the power amplifier is decreased. However, adjusting the voltage that is provided to the power amplifier may lead to voltage errors. The voltage errors may be determined as a voltage difference between a voltage that represents amplitude of an audio signal (e.g., a tracking voltage $V_{in\_TPS}$) and voltage output of a power output section of a boost circuit (e.g., $V_{out\_TPS}$). The voltage errors may result in sound level errors at speakers that are driven by the power amplifier.

SUMMARY

A boost circuit may increase a voltage level that is supplied to a power amplifier, but due to an indirect energy transfer mechanism, the boost circuit may exhibit a zero in a right half plane of the complex S plane. The zero in the right half plane may cause the output of the boost circuit to exhibit voltage tracking issues if the crossover frequency is chosen too close to the right half plane zero. For example, the gain of the boost circuit may increase by +20 decibels (dB) as the phase of the output voltage decreases when the frequency of input to the boost circuit increases. The right half plane zero introduces phase lag to the control loop. If the crossover frequency is chosen close to the right half plane zero, the phase margin of the control loop is reduced, and the control loop can become unstable.

The inventors have recognized that the voltage tracking capability of boost circuit output may be improved by adjusting a crossover frequency of a voltage control loop. In particular, the cross over frequency can be adjusted such that when the right half plane zero moves to a lower frequency, the crossover frequency automatically moves to a low frequency. Conversely, when the right half plane zero moves to a higher frequency, the crossover frequency automatically moves to a higher frequency. The crossover frequency is a frequency at which the gain crosses 0 dB when changing from a positive gain value to a negative gain value. For example, the right half plane zero may be at 9 kHz and the cross over frequency may be set at 1 kHz. However, a tracking error of the boost circuit may increase as a crossover frequency for the boost circuit is decreased. Additionally, a lower crossover frequency may increase the response time of the boost circuit and degrade the transient response of the boost circuit.

The dynamic range of the tracking signal is large and the tracking signal may be at low amplitude much of the time that the boost circuit is operational. During conditions when the tracking signal exhibits low amplitude, the boost circuit's zero in the right half plane may move to a much higher frequency (e.g., 90 kHz) as compared to when the boost circuit is operated at maximum power output. If the crossover frequency is maintained at 1 kHz, the error (e.g., a tracking error) between voltage output of the boost circuit and voltage of the tracking signal increases. Likewise, the transient response of the boost circuit degrades when the crossover frequency is low and the zero is moved to a higher frequency. By dynamically adjusting the crossover frequency it may be possible to reduce the voltage tracking error and maintain or improve transient response of the boost circuit. The present disclosure provides for a boost circuit comprising: a compensation circuit configured to adjust a voltage output of the boost circuit proportionate to the voltage output of the boost circuit and inversely proportionate to a current input to the boost circuit.

In a first example, the boost circuit includes wherein the compensation circuit includes a differential amplifier to adjust the voltage output of the boost circuit proportionate to the voltage output of the boost circuit. In a second example that may include the first example, the boost circuit includes wherein the compensation circuit includes a first metal oxide semiconductor field effect transistor and a first bipolar transistor coupled in parallel with a second metal oxide semiconductor field effect transistor and a second bipolar transistor. In a third example that may include one or both of the first and second examples, the boost circuit includes wherein the first metal oxide semiconductor field effect transistor is coupled in series to the first bipolar transistor. In a fourth example that may include one or more of the first through third examples, the boost circuit further comprises a third bipolar transistor and a fourth bipolar transistor. In a fifth example that may include one or more of the first through fourth examples, the boost circuit includes where a base of the third bipolar transistor is directly coupled to a base of the fourth bipolar transistor. In a sixth example that may include one or more of the first through fifth examples, the boost circuit further comprises a resistor, the resistor directly coupled to a collector of the third bipolar transistor, the base of the third bipolar transistor, and the base of the fourth bipolar transistor. In a seventh example that may include one or more of the first through sixth examples, the boost circuit further comprises an output of the differential amplifier that is directly coupled to an input of a battery current compensation circuit.

A tracking voltage, which may be referred to as voltage signal, may change in amplitude as amplitude of an audio signal changes. The boost circuit may be configured to adjust a magnitude of its voltage output in response to the tracking voltage so that efficiency of the boost circuit may be increased. However, the boost circuit may not follow the tracking signal as well as may be desired during some conditions if the boost circuit is configured with a fixed crossover frequency to improve operation of the boost circuit. The present disclosure overcomes the limitations of a boost circuit with a fixed crossover frequency.

As one example, the present disclosure provides for a method for operating a boost circuit, comprising: generating an adjusted voltage signal via adjusting a voltage proportionate to a voltage output of the boost circuit; and generating the adjusted voltage signal via adjusting the voltage inversely proportionate to an input current to the boost circuit. In other words, the output of the boost circuit may be adjusted in response to the output voltage of the boost circuit and the input current to the boost circuit. In this way, a crossover frequency of the boost circuit may be adjusted during boost circuit conditions where the frequency of the zero changes so that boost circuit response may be improved.

In a first example, the method includes where adjusting the voltage inversely proportionate to the input current to the boost circuit includes determining the input current to the boost circuit via a shunt resistor. In a second example that may include the first example, the method also includes where adjusting the voltage inversely proportionate to the input current of the boost circuit includes supplying output of a differential amplifier to a gate of a metal oxide semiconductor field effect transistor. In a third example that may include one or both of the first and second examples, the method includes where adjusting the voltage inversely proportionate to the input current of the boost circuit includes flowing a first current through the metal oxide semiconductor field effect transistor and a first bipolar transistor. In a fourth example that may include one or more of the first through third examples, the method includes where adjusting the voltage inversely proportionate to the input current of the boost circuit includes flowing a second current through the first bipolar transistor. In a fifth example that may include one or more of the first through fourth examples, the method includes where adjusting the voltage inversely proportionate to the input current of the boost circuit includes flowing a third current through a second bipolar transistor, where the third current is proportionate to a sum of the first current and the second current, and controlling a transconductance of the differential amplifier via the third current. In a sixth example that may include one or more of the first through fifth examples, the method includes where adjusting the voltage proportionate to the voltage output of the boost circuit includes generating a current via a current mirror circuit, and controlling the transconductance of the differential amplifier via the mirror circuit.

A tracking power supply may have a transfer function that includes a zero at a frequency in a right half plane. The frequency is a function of tracking power supply component values and operating conditions (e.g., inductance, output voltage, etc.). The frequency of the zero may change as the tracking power supply attempts to compensate for the tracking voltage or tracking signal. The present disclosure compensates for the changing frequency of the zero by adjusting a gain of the tracking power supply according to battery current that is supplied to the tracking power supply and output voltage of the tracking power supply. As a result, the system and method of the present disclosure need not monitor a frequency of tracking power supply switching or input frequencies to compensate for when the frequency of the zero changes.

In one or more examples, the present description provides for a tracking power supply comprising: a compensation circuit configured to adjust a voltage output of the boost circuit proportionate to the voltage output of the boost circuit and inversely proportionate to a current input to the boost circuit, the compensation circuit including a differential amplifier circuit, a battery current compensation circuit, and a boost circuit input current scaling circuit.

In a first example, the boost circuit includes where the first differential amplifier circuit includes a first input for the voltage output of the boost circuit, a reference voltage input, a feedback voltage input, and a current output. In a second example that may include the first example, the boost circuit includes where the battery current compensation circuit is a second differential amplifier circuit that includes four bipolar transistors and is directly coupled to the current output. In a third example that may include one or both of the first and second examples, the boost circuit includes where the battery current compensation circuit includes an output that is coupled to a power amplifier. In a fourth example that may include one or more of the first through third examples, the boost circuit includes where the boost circuit input current scaling circuit includes a shunt resistor and a third differential amplifier circuit.

BRIEF DESCRIPTION OF THE DRAWINGS

The disclosure may be better understood from reading the following description of non-limiting embodiments, with reference to the attached drawings, wherein below:

FIG. 1 shows a plan view of a vehicle that includes an infotainment system with a power amplifier;

FIG. 2 shows a block diagram of an example closed loop boost circuit for a power amplifier;

FIG. 3 shows an example circuit for providing adaptive control loop compensation for a boost circuit;

FIGS. 4 and 5 show example plots of compensated boost circuit output;

FIGS. 6-8 show boost circuit gain examples;

FIG. 9 shows a plot of how gain of a voltage control loop of a tracking power supply may be adjusted to compensate for a zero of the tracking power supply;

FIG. 10 shows a plot of tracking error of an uncompensated boost circuit;

FIG. 11 shows a plot of tracking error for a compensated boost circuit;

FIGS. 12A and 12B show uncompensated boost circuit output voltage for increasing and decreasing boost voltages;

FIGS. 13A and 13B show compensated boost circuit output voltage for increasing and decreasing boost voltages; and

FIG. 14 shows a flowchart of a method for providing compensation to a boost circuit.

## DETAILED DESCRIPTION

The disclosure provides for systems and methods that address the above-described issues that may arise when a power stage of an audio power amplifier is applied to boost output of an infotainment system. The infotainment system may be included in a vehicle that includes a battery as an electric power source. The infotainment system may output audio signals of prerecorded or broadcast music, conversations, movie sound tracks, etc. to speakers in the vehicle. The speakers may be driven via a power amplifier and the power amplifier may be supplied with a voltage that varies in magnitude according to amplitude of an audio signal. A compensation circuit according to the present description may have a gain that automatically adjusts for a frequency of a tracking signal. The adjustable gain may improve transient response of the power stage and reduce voltage errors of the power stage.

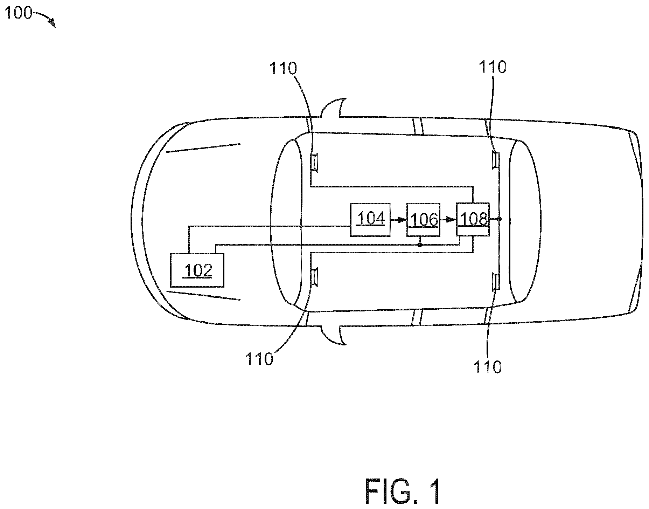

FIG. 1 shows a vehicle 100 that includes an infotainment system 104 that includes a boost circuit 106 and a power amplifier 108. The power amplifier 108 amplifies signals from the infotainment system and drives speakers 110. The power amplifier and the infotainment system are supplied with electrical power via low voltage battery 102 (e.g., a 12 Volt battery). Power that is delivered to power amplifier 108 is boosted to a higher voltage than the voltage that is supplied by low voltage battery 102. Boost circuit 106 (e.g., a tracking power supply) boosts power that is supplied to power amplifier 108 to a higher voltage than the voltage of low voltage battery 102. The infotainment system 104 may include a head unit (not show) and software (not shown). The head unit may be comprised of one or more hardware elements of in-vehicle including a computing system (not shown), a touch screen (not shown), a display screen (not shown), various control elements (e.g., dials, knobs and buttons) (not show), memory (not shown), processor(s)(not shown), and any interface elements (e.g., connectors or ports) (not shown) may form an integrated head unit that is installed in an instrument panel of a vehicle.

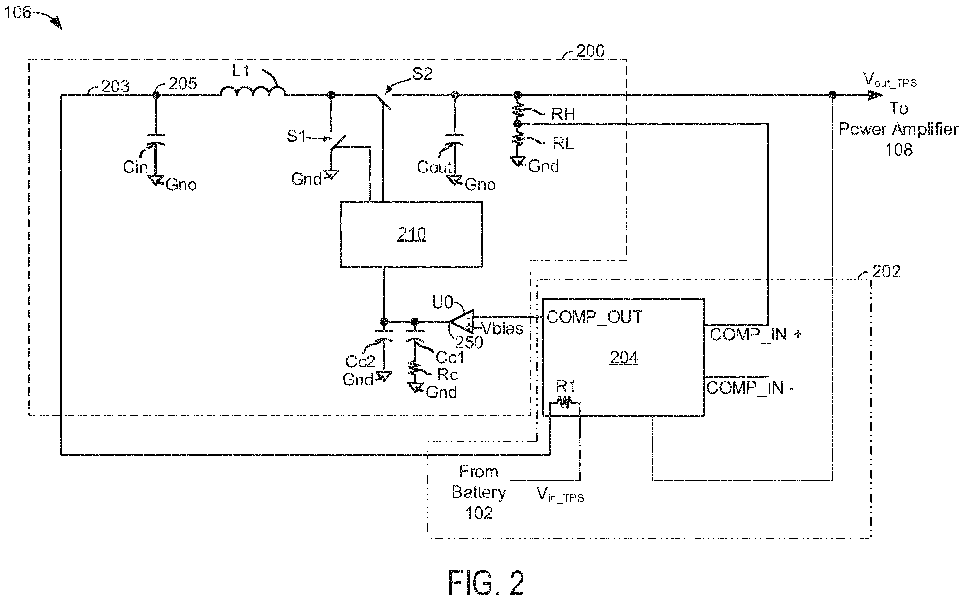

Referring now to FIG. 2, a diagram of boost circuit 106 is shown. Boost circuit 106 is bisected into two sections. The first section 200 is a power output section and the second section 202 is a compensation section.

With regard to the circuitry disclosed herein, when terminology "directly coupled" is used to describe how a first electrical component (e.g., transistor, resistor, diode, capacitor, inductor, integrated circuit, etc.) is coupled to a second electrical component, it is to be understood as meaning that the first electrical component is coupled to the second electrical component without any other intervening electrical components other than a conductor or wire. Lines, such as line 203, between the various components are to be understood as conductors and nodes are indicated as shown at 205.

In this example, the boost circuit 106 receives a signal $V_{in\_TPS}$ that is a basis for adjusting the voltage output $V_{out\_TPS}$ of the boost circuit 106. The signal $V_{in\_TPS}$ includes a voltage that varies as amplitude of an audio signal output from infotainment system 104 varies. For example, if the amplitude of the audio signal output increases, the voltage level of the signal $V_{in\_TPS}$ increases. The boost circuit 106 increases its voltage output $V_{out\_TPS}$ when the voltage level of signal $V_{in\_TPS}$ increases. If the amplitude of the audio signal output decreases, the voltage level of the signal $V_{in\_TPS}$ decreases. The boost circuit 106 decreases its voltage output $V_{out\_TPS}$ when the voltage level of signal $V_{in\_TPS}$ decreases. By adjusting the voltage that is output by the boost circuit 106 according to amplitude of an audio signal, efficiency of the boost circuit 106 may be improved.

The signal $V_{in\_TPS}$ is input to resistor R1 of compensation circuit 204, which is included in the second section 202. Resistor R1 is directly coupled to capacitor Cin and inductor L1. Inductor L1 is directly coupled to switch S1 and switch S2. Switches S1 and S2 may be implemented via field effect transistors. Switches S1 and S2 are opened and closed via pulse width generator 210. Switch S2 is directly coupled to output capacitor Cout and a voltage divider that is comprised of resistors RH and RL. The second switch S2 also provides the output voltage $V_{out\_TPS}$ to the power amplifier. The voltage divider circuit that is comprised of resistors RH and RL is input to compensation circuit input COMP_IN +. For simplification purposes, the output of the voltage divider that is comprised of RH and RL may be equated to $V_{out\_TPS}$. Output of compensation circuit 204 COMP_OUT is directly coupled to inverting input of operational amplifier U0. A bias signal Vbias is input to non-inverting input of operational amplifier U0. Output 250 of operational amplifier U0 is directly coupled to capacitors Cc1, Cc2, and pulse width generator 210. Capacitor Cc1 is directly coupled to resistor Rc.

The boost circuit 106 may include an indirect energy transfer mechanism that causes a zero in a right half plane. The frequency at which the zero occurs may be determined via the following equation:

$$f_{RHPZ} = \frac{R_{load} \cdot (1-D)^2}{2\pi \cdot L} = \frac{V_{in\_TPS}^2}{2\pi \cdot L \cdot P_{out\_TPS}} \approx \frac{V_{in\_TPS}}{2\pi \cdot L \cdot I_{TPS\_IN}} \qquad (1)$$

where $f_{RHPZ}$ is the right half plane zero frequency, $R_{load}$ is the load resistance seen by the boost circuit, L is the inductance of the inductor L1 of the boot circuit, $P_{out\_TPS}$ is the output power of the tracking power supply, $V_{in\_TPS}$ is the voltage that is input to the tracking power supply (e.g., battery voltage), D is the duty cycle of a pulse width modulation that is internal to the boost circuit, and $I_{TPS\_IN}$ is current flow into the tracking power supply from the vehicle's battery

The boost circuit 106 may have an output voltage error may be expressed via the following equation:

$$V_{error}(f) = \frac{1}{1+G_{loop}(f)} \cdot V_{in\_TPS}(f) \qquad (2)$$

where $V_{error}$ is the voltage error as a function of frequency f, $G_{loop}$ is the open loop gain of the tracking power supply as a function of frequency f, and $V_{in\_TPS}$ is the input voltage to the boost circuit 106. The tracking voltage error may also be expressed by the following equation:

$$V_{error}(f) = \frac{1}{1+j\frac{f_c}{f}} \cdot V_{tracking}(f) \qquad (3)$$

where fc is the control loop crossover frequency for the tracking power supply, and f is frequency that is input to boost circuit 106 via the $V_{in\_TPS}$. It may be observed that the voltage error increases as the control loop crossover frequency decreases. In addition, the control loop crossover frequency affects the transient response of the tracking power supply.

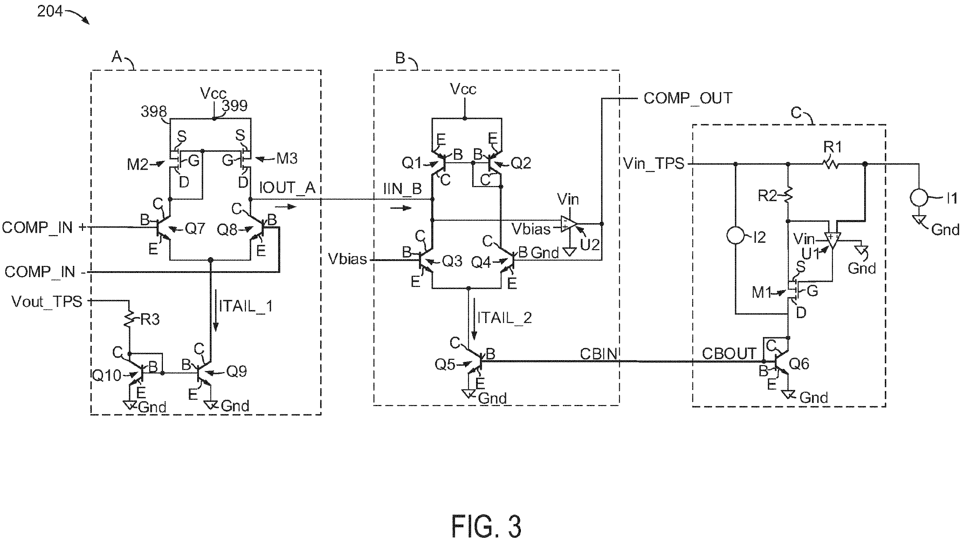

Referring now to FIG. 3, a detailed view of compensation circuit 204 is shown. With regard to the circuitry disclosed herein, Vcc is a supply voltage (e.g., 5 VDC) and Gnd is electrical ground for the circuitry. Lines 398 between the various components are to be understood as conductors and nodes are indicated as shown at 399.

Compensation circuit 204 is designed to increase the crossover frequency of the tracking power supply when the tracking power supply is delivering low output power. The compensation circuit 204 automatically adjusts the crossover frequency via adjusting circuit gain. In particular, the compensation circuit 204 receives tracking power supply input current from the vehicle's battery and tracking power supply output voltage as inputs to adjust the crossover frequency of the tracking power supply with respect to the right half plane zero frequency. The compensation circuit 204 is based on the following equations:

$$\frac{1}{G_{I \to V}} \cdot (1-D) \cdot \frac{1}{2\pi \cdot f_c} \cdot \beta \cdot G_{comp} = 1 \qquad (4)$$

$$f_c = \frac{1}{G_{I \to V}} \cdot (1-D) \cdot \frac{1}{2\pi \cdot C_{out}} \cdot \beta \cdot G_{comp} \qquad (5)$$

$$f_c = \left(\frac{1}{3} to \frac{1}{5}\right) \cdot f_{RHPZ} \qquad (6)$$

$$\frac{1}{G_{I \to V}} \cdot (1-D) \cdot \frac{1}{2\pi \cdot f_c} \cdot \beta \cdot G_{comp} = \left(\frac{1}{3} to \frac{1}{5}\right) \cdot \frac{V_{in\_TPS}}{2\pi \cdot L \cdot I_{TPS\_IN}} \qquad (7)$$

$$G_{comp} \propto \frac{1}{I_{TPS\_IN}} \cdot V_{out\_TPS} \qquad (8)$$

where equation 4 is the loop gain for the tracking power supply, equation 5 is used to determine the crossover frequency and it is derived from equation 5, equation 6 is a basis for adjusting $f_c$ to move in the right half plane, equation 7 is equation 4 combined with equation 6, where equation 1 is substituted into equation 6 for $f_{RHPZ}$. In equations 4-6, $\beta$ is the feedback gain, which is set to a value of 1 for simplification in this example, $G_{I \to V}$ is the input current to voltage gain for the current sensing circuit (e.g., circuit B), $C_{out}$ is the output capacitor for the boost circuit, $G_{comp}$ is the gain of the compensation circuit 204, $V_{out\_TPS}$ is the output voltage of the tracking power supply, and the remaining variables are as previously described. Thus, the gain for the compensation circuit is proportional to the tracking power supply output voltage and inversely proportional to the tracking power supply input electric current.

Compensation circuit 204 has been subdivided into three circuits based on functionality of the circuits. Circuit A is a tracking power supply output voltage compensation circuit. The transconductance of circuit A as adjusted by the tracking power supply output voltage. Circuit B is a tracking power supply input electric current compensation circuit and its gain is adjusted in response to tracking power supply input electric current (e.g., electric current that is supplied by the vehicle's battery). Circuit C is a current scaling circuit that scales a small portion of the tracking power supply input electric current to control the gain of circuit B.

Circuit A is configured as a differential amplifier and it includes four bipolar NPN transistors Q7-Q10, two N-channel Metal Oxide Semiconductor Field Effect Transistors (MOSFETs) M2 and M3, and one resistor R3. The bases of bipolar transistors are indicated as B. The collectors of bipolar transistors are indicated as C. The emitters of bipolar transistors are indicated as E. The sources of MOSFETs are indicated by S. The gates of MOSFETs are indicated by G. The drains of MOSFETs are indicated by D.

COMP_IN+ and COMP_IN- are inputs to the tracking output voltage compensation circuit A. COMP_IN+ may receive the $V_{out\_TPS}$ signal and COMP_IN - may receive the $V_{in\_TPS}$ - signal from the infotainment system. $V_{out\_TPS}$ is an input that receives the tracking power supply output voltage $V_{out\_TPS}$. Vcc is the power supply voltage that is supplied to the voltage compensation circuit A. IOUT_A is the output of the voltage compensation circuit A, which is an electric current.

In circuit A, Vcc is directly coupled to the sources of M2 and M3. The gates of M2 and M2 are directly coupled to each other and the drain of M2 is directly coupled to the gates of M2 and M3. The drain of M2 is directly coupled to the collector of Q7 and the drain of M3 is directly coupled to the collector of Q8. The base of Q7 is directly coupled to input COMP_IN + and the base of Q8 is directly coupled to input COMP_IN -. The emitters of Q7 and Q8 are directly coupled to each other and the collector of Q9. The emitters of Q9 and Q10 are directly coupled to ground. Thus, M2 is in series with Q7 and M3 is in series with Q8. M2 and Q7 are arranged in parallel with M3 and Q8. The bases of Q9 and Q10 are directly coupled together and to the collector of Q10. The collector of Q10 is directly coupled to resistor R3 and resistor R3 is directly coupled to input $V_{out\_TPS}$.

The gain of circuit A may be expressed via the following equation:

$$G_A = \frac{IOUT\_A}{V_{COMP\_IN}} = \frac{I_{C\_Q7}}{V_T} = \frac{0.5 \cdot I_{TAIL\_1}}{V_T} = \frac{0.5 \cdot (V_{out\_TPS} - V_{be10})}{R_3 \cdot V_T} \approx \frac{0.5 \cdot V_{out\_TPS}}{R_3 \cdot V_T} \qquad (9)$$

where $G_A$ is the gain of circuit A, $I_{C\_Q7}$ is the electric current flow through transistor Q7, $V_T$ is the thermal voltage (which is proportional to temperature, and around 25mV at room temperature), $R_3$ is the resistance of resistor R3, $V_{be10}$ is the based to emitter voltage of transistor Q10, $I_{TAIL\_1}$ is the electric current flow from the emitters of Q7 and Q8 to the collector of Q9, and $V_{OUT\_TPS}$ is the voltage output of the tracking power supply. Thus, the gain of transistor Q7 is proportionate to its collector current and its collector current is half of the tailer current $I_{TAIL\_1}$. The tailer current $I_{TAIL\_1}$ is proportionate to the tracking power supply output voltage $V_{OUT\_TPS}$ when neglecting $V_{be}$ of transistor Q10 since Q10 and Q9 form a current mirror in which current flow is regulated by the tracking power supply output voltage $V_{OUT\_TPS}$ and the value of resistor R3.

Circuit B is configured as a battery current compensation circuit and it includes three bipolar NPN transistors Q3-Q5, two PNP transistors Q1 and Q2, and a differential amplifier U2 (e.g., a second differential amplifier circuit).

IIN_B, CBIN, and VBIAS are inputs to circuit B and COMP_OUT is the output of circuit B. IIN_B is coupled to output IOUT_A of circuit A and VBIAS is an externally generated bias voltage. CBIN is coupled to CBOUT of circuit C.

In circuit B, Vcc is directly coupled to the emitters of Q1 and Q2. The bases of Q1 and Q2 are directly coupled to each other and the collector of Q2 is directly coupled to the bases of Q1 and Q2. The collector of Q1 is directly coupled to the collector of Q3 and the collector of Q2 is directly coupled to the collector of Q4. The base of Q3 is directly coupled to input IIN_B and the base of Q4 is directly coupled to output COMP_OUT. The emitters of Q3 and Q4 are directly coupled to each other and the collector of Q5. Thus, Q1 is in series with Q3 and Q2 is in series with Q4. Q1 and Q3 are arranged in parallel with Q2 and Q4. The emitter of Q5 is directly coupled to ground. The base of Q5 is directly coupled to input CBIN. The collectors of Q1 and Q3 are directly coupled to the inverting input (-) of differential amplifier U2. VBIAS is directly coupled to the non-inverting input (+) of differential amplifier U2. The output of differential amplifier U2 is directly coupled to output COMP_OUT and the base of Q4.

The gain of circuit B may be expressed via the following equation:

$$G_B = \frac{V_{COMP\_OUT}}{I_{IN\_B}} = \frac{V_T}{0.5 \cdot I_{TAIL\_2}} \quad (10)$$

where $G_B$ is the gain of circuit B, $V_T$ is the thermal voltage, $I_{IN\_B}$ is the electric current that is input to circuit B, $I_{TAIL\_2}$ is the electric current flow from the emitters of Q3 and Q4 to the collector of Q5, and $V_{COMP\_OUT}$ is the compensation voltage that is output from circuit B. The output voltage of the tracking power supply may be adjusted responsive to the $V_{COMP\_OUT}$ signal. Thus, the gain of circuit B is inversely proportional to the tracking power supply input current.

Circuit C is configured as a boost circuit input electric current scaling circuit and it includes one bipolar NPN transistor Q6, one N-channel MOSFET M1, a differential amplifier U1, a current source I2, and two resistors R1 and R2.

$V_{in\_TPS}$ (e.g., vehicle battery voltage) is the input to circuit C and CBOUT and I1 are the outputs of circuit C. $V_{in\_TPS}$ is directly coupled to electric current source I2 and resistors R1 and R2. Resistor R2 is directly coupled to the source of MOSFET M1 and the inverting input of differential amplifier U1 (e.g., a third differential amplifier circuit). Resistor R1 is directly coupled to the non-inverting input of differential amplifier U1 and boost circuit 106. Boost circuit 106 is electrically coupled to electric current source I1 (e.g., the power amplifier 108). The output of differential amplifier U1 is input to the gate of MOSFET M1. The drain of MOSFET M1 is directly coupled to the electric current source I2 and the collector of transistor Q6. The collector of transistor Q6 is directly coupled to the base of transistor Q6.

Resistor R1 is a tracking power supply input electric current shunt resistor and the voltage across R1 and the voltage across R2 are equal due to the feedback loop of U1. R1 is configured to measure current flow into the tracking power supply from the vehicle's battery. The amount of electric current in R2 is the scaled tracking power supply input electric current. Resistor R1 and resistor R2 may be sized to provide 1/100,000 times the tracking power supply current. The electric current flow through transistor Q6 may be determined via the following equation:

$$I_{C\_Q6} = \left(\frac{R1}{R2} \cdot I_{TPS\_IN} + I_2\right) \quad (11)$$

where $I_2$ is current flow through current source I2, $I_{C\_Q6}$ is the electric current flowing through the collector of transistor Q6, $I_{TPS\_IN}$ is the electric current flow into the tracking power supply from the vehicle's battery. Note that the electric current I2 is added to the collector current of Q6 to hold Q6 collector current above a threshold level. Transistor Q6 and transistor Q5 form a current mirror. The current IT AIL _2 in circuit B is equal to the current in the collector of transistor Q6, which allows equation 10 to be revised to the following equation:

$$\frac{V_{COMP\_OUT}}{I_{IN\_B}} = \frac{V_T}{0.5 \cdot \left(\frac{R1}{R2} \cdot I_{TPS\_IN} + I_2\right)} \quad (12)$$

The total gain for circuits A and B may be determined via combining equations 9 and 12 as shown in the following equation:

$$\frac{V_{COMP\_OUT}}{V_{COMP\_IN}} = -\frac{0.5 \cdot V_{OUT_{TPS}}}{R3 \cdot V_T} \cdot \frac{V_T}{0.5 \cdot \left(\frac{R1}{R2} \cdot I_{TPS_{IN}} + I_2\right)} = -\frac{1}{R3} \cdot \frac{V_{OUT\_TPS}}{\left(\frac{R1}{R2} \cdot I_{TPA\_IN} + I_2\right)} \quad (13)$$

Thus, the gain of compensation circuit 204 is proportional to the tracking power supply output voltage. In addition, when current I2 is negligible as compared to the scaled tracking power supply input electric current, the gain in inversely proportional to the tracking power supply input electric current. As such, equation 8 is met by compensation circuit 204.

The compensation circuit of FIG. 3 operates according to the following description. Circuit A is a differential amplifier and its input is voltage signal COMP_IN+ and COMP_IN-. Its output is a current signal IOUT_A. Transistors M2 and M3 form a current mirror, which means that the current flowing through M2 and the current flowing through M3 are equal. Transistors Q7 and Q8 are differential pair. Current flowing from the collector to the emitter (Ice) of transistor Q9 is a tail current for the differential pair Q7 and Q8. Transistors Q9 and Q10 are also form a current mirror, which means current flowing from the collector of transistor Q9 to the emitter of transistor Q9 (Ice9) is equal to current flowing from the collector of transistor Q10 to the emitter of Q10 (Ice10). Ice10 depends on the boost circuit voltage as follows: Ice10 = ($V_{out\_TPS}$ - Vbe10) / R3. The gain (e.g., transconductance since circuit output is current and circuit input is voltage) of the differential amplifier changes with the tail current, and the tail current changes when the boost circuit output voltage changes. So the gain of the differential amplifier in circuit A changes with the boost circuit output voltage.

Circuit C is current sensing circuit. U1 is operational amplifier. Due to negative feedback, the inverting input (-) and non-inverting input (+) voltage of U1 are equal. Therefore, a voltage across resistors R1 and R2 is equal. As a numerical example, if R2 is 10,000 times R1, then the current in R2 is 1/10,000 times the R1 current. The current in transistor M1 equals the current in resistor R2 current since the operational amplifier input terminal absorbs very little current. Consequently, the current flow through transistor Q6 (e.g., Ice6) is the sum of current flow through I2 and current flow through R2, or I2 plus 1/10,000 times R1 current. The R1 current is a load current that may be up to tens of amperes, while R2 current is a small fraction current that may be up to several milli- amperes using the above 1/10,000 number.

Circuit B is another differential amplifier and its input is current signal IIN_B. Its output is voltage signal COMP_OUT. Transistors Q1 and Q2 are a current mirror and transistors Q3 and Q4 form a differential pair. Transistor Q5 provide tail current. The gain of this differential amplifier also changes with the tail current of transistor Q5 (Ice5). Transistors Q5 and Q6 form a current mirror. Therefore, current flow through transistor Q5 (Ice5) is equal to current flow through transistor Q6 (Ice6). Since current Ice6 changes with load current, the gain of the differential amplifier also changes with the load current.

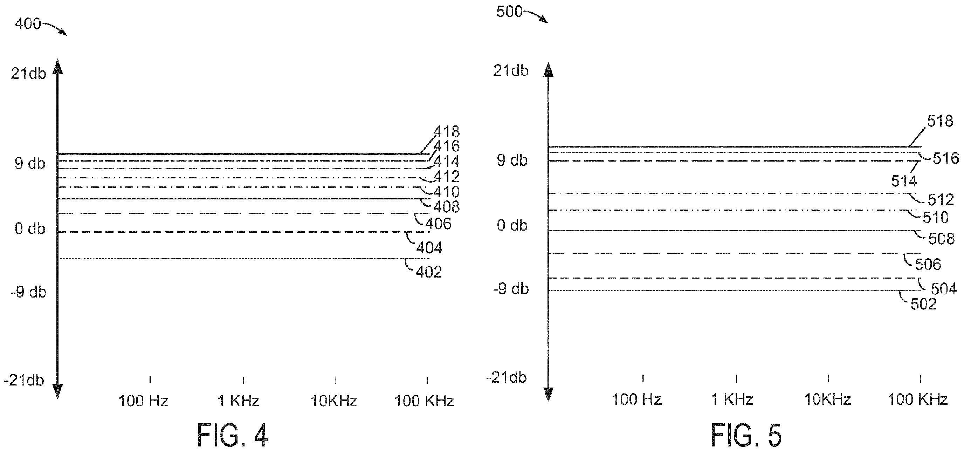

Referring now to FIG. 4, a plot 400 of how the gain of compensation circuit 204 changes in response to a change in the output voltage of the tracking power supply is shown. The vertical axis represents the gain of compensation circuit 204 (e.g., COMP_OUT) and gain of compensation circuit 204 is in units of decibels (dB). The horizontal axis represents input frequency to block circuit A (e.g., the frequency of IOUT_A, COMP_IN+, COMP_IN-) and the input frequency increases from the left side of plot 400 to the right side of plot 400.

Line 402 represents gain of compensation circuit 204 for a tracking power supply output of 10 volts. Line 404 represents gain of compensation circuit 204 for a tracking power supply output of 15 volts. Line 406 represents gain of compensation circuit 204 for a tracking power supply output of 20 volts. Line 408 represents gain of compensation circuit 204 for a tracking power supply output of 25 volts. Line 410 represents gain of compensation circuit 204 for a tracking power supply output of 30 volts. Line 412 represents gain of compensation circuit 204 for a tracking power supply output of 35 volts. Line 414 represents gain of compensation circuit 204 for a tracking power supply output of 40 volts. Line 416 represents gain of compensation circuit 204 for a tracking power supply output of 45 volts. Line 418 represents gain of compensation circuit 204 for a tracking power supply output of 50 volts.

Thus, it may be observed that the gain of compensation circuit 204 increases as the output voltage of the tracking power supply increases. This provides the benefit of being part of the solution to modify the crossover frequency in response to the frequency of the tracking power supply zero that is in the right half plane.

Referring now to FIG. 5, a plot 500 of how the gain of compensation circuit 204 changes in response to a change in the input electric current to the tracking power supply is shown. The vertical axis represents the output of compensation circuit 204 (e.g., COMP_OUT) and output of compensation circuit 204 is in units of decibels (dB). The horizontal axis represents input and output frequency to the block circuit B, and the frequency increases from the left side of plot 500 to the right side of plot 500.

Line 502 represents gain of compensation circuit 204 for a tracking power supply output of 50 amperes. Line 504 represents gain of compensation circuit 204 for a tracking power supply output of 39.8 amperes. Line 506 represents gain of compensation circuit 204 for a tracking power supply output of 25.1 amperes. Line 508 represents gain of compensation circuit 204 for a tracking power supply output of 15.8 amperes. Line 510 represents gain of compensation circuit 204 for a tracking power supply output of 10 amperes. Line 512 represents gain of compensation circuit 204 for a tracking power supply output of 6.3 amperes. Line 514 represents gain of compensation circuit 204 for a tracking power supply output of 1.58 amperes. Line 516 represents gain of compensation circuit 204 for a tracking power supply output of 0.63 amperes. Line 518 represents gain of compensation circuit 204 for a tracking power supply output of 0.1 amperes.

Thus, it may be observed that the gain of compensation circuit 204 decreases as the input current to the tracking power supply increases. This provides the benefit of being part of the solution to modify the crossover frequency in response to the frequency of the tracking power supply zero that is in the right half plane.

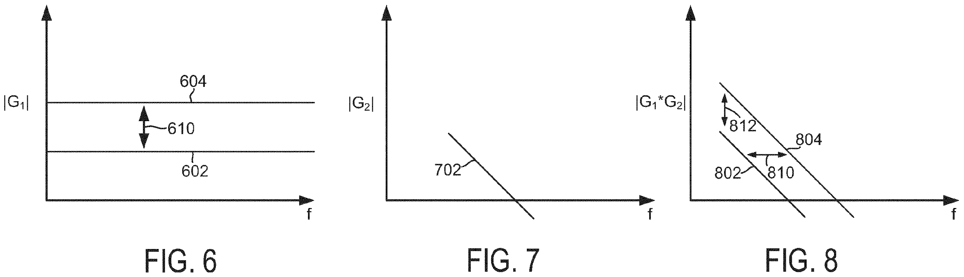

FIG. 6 is a plot of gain of compensation circuit 204. The vertical axis represents gain $|G_1|$ of the compensation circuit 204 and the horizontal axis represents a frequency. It may be observed that the gain $|G_1|$ may increase and decrease independent of the frequency as shown in FIG. 4. In particular, the gain $|G_1|$ of the compensation circuit 204 may increase from the level of line 602 to the level of line 604. The gain $|G_1|$ may increase and decrease as indicated by arrow 610.

FIG. 7 is a plot of the gain $|G_2|$ of a first section 200 of a power output section of boost circuit 106 is shown. The vertical axis represents gain $|G_2|$ of the first section 200 of a power output section of boost circuit 106 and the horizontal axis represents a frequency. It may be observed that the gain $|G_2|$ may decrease as frequency increases. In particular, the gain $|G_2|$ of the first section 200 may decrease a frequency f increase. The gain $|G_2|$ increases as the frequency decreases.

FIG. 8 is a plot of combined gain (e.g., $|G_1{}^*G_2|$) of compensation circuit 204 and first second 200. The combined gain may change the crossover frequency for the boost circuit 106. The vertical axis represents the combined gain $|G_1{}^*G_2|$ for the first section 200 and the second section 202 of the boost circuit 106. The horizontal axis represents a frequency of the $V_{in\_TPS}$ signal. Line 802 represents the combined gain for boost circuit operating conditions when the zero of the tracking power supply that is in the right half plane is at a lower frequency, such as during conditions when the tracking power supply is operating near maximum power. Line 804 represents the combined gain for boost circuit operating conditions when the zero of the boost circuit that is in the right half plane is at a higher frequency, such as during conditions when the tracking power supply is operating near minimum power. The combined gain of the boost circuit may change as a function of frequency as indicated by arrows 810 and 812. The compensation circuit 204 does not respond directly to an input frequency to the tracking power supply. Instead, the compensation circuit 204 responds to input current to the tracking power supply and output voltage of the tracking power supply to change the gain of the voltage control loop of the tracking power supply. The gain of the voltage control loop is adjusted automatically based on current flow into the tracking power supply and voltage output of the tracking power supply based on a recognition that the frequency of the zero of the tracking power supply changes with power output of the tracking power supply. Notice that as $|G_1|$ moves up and down, $|G_1{}^*G_2|$ moves up and down accordingly. This causes the location of where the combined gain intersects with the horizontal axis (e.g., $|G|$ =0dB) to move left and right, which means that the crossover frequency mover from left to right. Thus, the gain of the voltage control loop may be adjusted according to current flow into the tracking power supply and voltage output of the tracking power supply to adjust the crossover frequency relative to the zero of the tracking power supply.

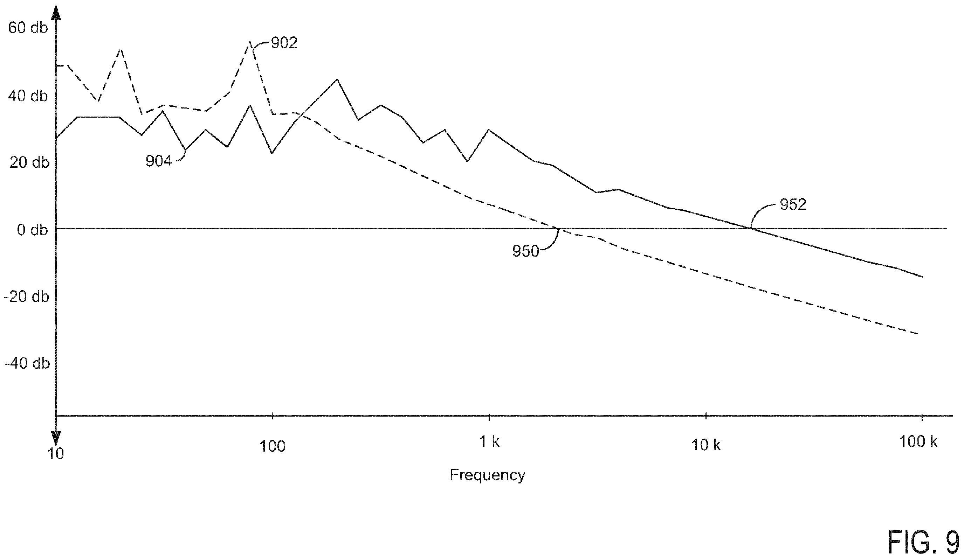

Referring now to FIG. 9, a plot that shows how voltage loop gain may be adjusted to change a crossover frequency of a voltage control loop of a tracking power supply is shown. The vertical axis represents gain of the voltage control loop of the tracking power supply. The gain values in decibels (dB) are indicated along the vertical axis. The horizontal axis represents frequency and frequency values are indicated along the horizontal axis.

Dashed line trace 902 represents the voltage control loop gain with respect to frequency for an uncompensated voltage control loop or voltage control loop gain with respect to frequency for a compensated voltage control loop when the tracking power supply is operating near maximum power output. The crossover frequency for dashed line trace 902 is indicated at 950. Solid line trace 904 represents the voltage control loop gain with respect to frequency for a compensated voltage control loop with respect to frequency when the tracking power supply is operating near minimum power output. The crossover frequency for solid line trace 904 is indicated at 952. Thus, the crossover frequency may be adjusted by adjusting the voltage control loop gain to improve the transient response and reduce the tracking error of a voltage control loop of a tracking power supply.

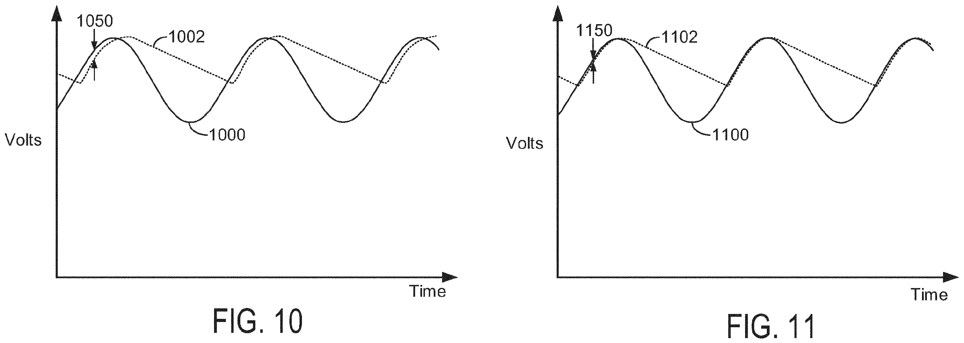

Turning now to FIG. 10, a plot of a tracking error between output voltage $V_{out\_TPS}$ of a boost circuit 106 and an input voltage $V_{in\_TPS}$ to the boost circuit is shown. In this example, compensation is not provided to adjust the crossover frequency. The vertical axis represents voltage and voltage increases in the direction of the vertical axis arrow. The horizontal axis represents time and time increases from the left side of the plot to the right side of the plot. The scale of FIG. 10 is equivalent to the scale of FIG. 11 so that a visual comparison may be made.

Trace 1000 represents the input voltage $V_{in\_TPS}$ to the boost circuit 106. The boost circuit 106 attempts to follow the input voltage $V_{in\_TPS}$ so that efficiency of the tracking power supply may be improved. Trace 1002 represents the actual voltage that is output by the boost circuit 106 and trace 1000 represents the voltage that is to be followed by the boost circuit. Notice the gap between trace 1000 and trace 1002 as indicated at 1050. This gap between the tracking voltage and the output voltage of the tracking power supply represents the voltage error. The voltage error is indicative of the boost circuit's tracking inability to follow a change in load on the boost circuit.

Referring now to FIG. 11, a plot of an error between output voltage of a boost circuit (e.g., $V_{out\_TPS}$) and an input voltage (e.g., $V_{in\_TPS}$) to the boost circuit 106 is shown. In this example, compensation is provided to adjust the crossover frequency. The vertical axis represents voltage and voltage increases in the direction of the vertical axis arrow. The horizontal axis represents time and time increases from the left side of the plot to the right side of the plot.

Trace 1100 represents the input voltage $V_{in\_TPS}$ that is input to the boost circuit. The tracking power supply attempts to follow the tracking voltage so that efficiency of the tracking power supply may be improved. Trace 1002 represents the output voltage $V_{out\_TPS}$ of the boost circuit. Notice the gap between trace 1100 and trace 1102 as indicated at 1150. This gap is smaller than the gap that is indicated at 1050 of FIG. 10. The voltage error gap of FIG. 11 indicates that adjusting the crossover frequency is an effective way to reduce the error voltage and improve the boost circuit's ability to follow a change in load on the boost circuit.

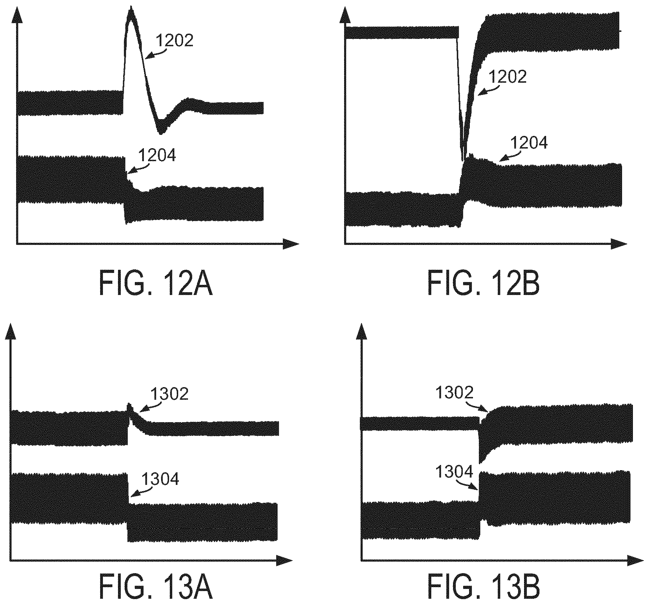

Moving on to FIGS. 12A and 12B, plots are shown of output voltages of an uncompensated boost circuit when a load on the boost circuit is increased and decreased. In particular, FIG. 12A is a plot of output voltage of the boost circuit when a load decrease occurs. Trace 1202 represents tracking power supply output voltage and trace 1204 represents boost circuit inductor current. FIG. 12B is a plot of output voltage of the boost circuit when a load increase occurs. In FIG. 12A, the output voltage increases because the uncompensated boost circuit lacks the capacity to compensate from the decrease in load, which causes a decrease in current flow from the boost circuit and a temporary increase in voltage output of the boost circuit. In FIG. 12B, the output voltage decreases because the uncompensated boost circuit lacks the capacity to compensate from the increase in load, which causes an increase in current flow from the uncompensated boost circuit and a temporary decrease in voltage output of the uncompensated boost circuit. The scale of FIG. 12A is equivalent to the scale of FIG. 13A so that a visual comparison may be made. Likewise, the scale of FIG. 12B is equivalent to the scale of FIG. 13B so that a visual comparison may be made.

Referring now to FIGS. 13A and 13B, plots of output voltages of a compensated boost circuit when a load on the boost circuit is increased and decreased are shown. In particular, FIG. 13A is a plot of output voltage of the compensated boost circuit when a load decrease occurs. Trace 1302 represents boost circuit output voltage and trace 1304 represents tracking power supply inductor current. FIG. 13B is a plot of output voltage of the compensated boost circuit when a load increase occurs. In FIG. 13A, the output voltage increases considerably less than in FIG. 12A because the crossover frequency of the boost circuit has been adjusted to better compensate for the decrease in load. In FIG. 13B, the output voltage decreases considerably less than in FIG. 12B because the crossover frequency of the boost circuit has been adjusted to better compensate for the increase in load.

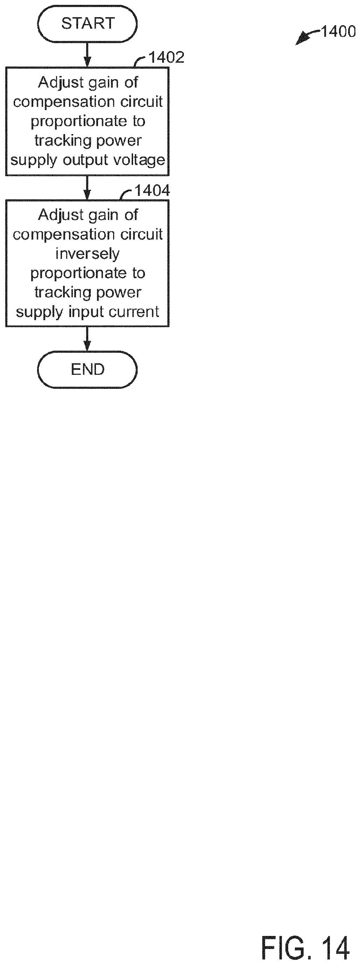

Finally, FIG. 14 is a flowchart of a method for adjusting operation of a tracking power supply that provides electric power to a power amplifier of an infotainment system of a vehicle. The method of FIG. 14 may be performed via circuitry that responds to changes in tracking power supply output voltage and tracking power supply input electric current. The method of FIG. 14 may operate as shown in FIGS. 4,5, 8, 9, 11, 13A, and 13B. The method of FIG. 14 may be performed via the circuitry in FIG. 3.

At 1402, method 1400 adjusts the gain of the compensation circuit 204 in FIGS. 2 and 3 proportionate to the output voltage of the tracking power supply. The output voltage of the tracking power supply may be input to a compensation circuit as shown in FIG. 3. The compensation circuit may generate an electric current that is based on the output voltage of the tracking power supply. Adjusting the gain of the compensation circuit may include increasing the gain of the compensation circuit such that the output of the compensation circuit increases as the output voltage of the tracking power supply increases. Similarly, adjusting the gain of the compensation circuit may include decreasing the gain of the compensation circuit such that the output of the compensation circuit decreases as the output voltage of the tracking power supply decreases. Method 1400 proceeds to 1404.

At 1404, method 1400 adjusts the gain of the compensation circuit 204 in FIGS. 2 and 3 inversely proportionate to the input current of the tracking power supply. The input current of the tracking power supply may be determined via a shut resistor as shown in FIG. 3. The compensation circuit may generate an electric current that is based on the current that is input to the tracking power supply. Adjusting the gain of the compensation circuit may include increasing the gain of the compensation circuit such that the output voltage of the compensation circuit increases as the input current to the tracking power supply decreases. Similarly, adjusting the gain of the compensation circuit may include decreasing the gain of the compensation circuit such that the output voltage of the compensation circuit decreases as the input current to the tracking power supply increases. Method 1400 proceeds to exit.

In this way, method 1400 may adjust the gain of the compensation circuit to compensate for changes to input current to the tracking power supply and output voltage of the tracking power supply. By adjusting the gain, the crossover frequency of the voltage control loop of the tracking power supply may be adjusted. The gain adjustments may reduce voltage tracking errors and improve the response of the tracking power supply.

The description of embodiments has been presented for purposes of illustration and description. Suitable modifications and variations to the embodiments may be performed in light of the above description or may be acquired from practicing the methods. For example, unless otherwise noted, one or more of the described methods may be performed by a suitable device and/or combination of devices, such as the circuitry shown in FIG. 3. The described systems are exemplary in nature, and may include additional elements and/or omit elements. The subject matter of the present disclosure includes all novel and non-obvious combinations and subcombinations of the various systems and configurations, and other features, functions, and/or properties disclosed.

As used in this application, an element or step recited in the singular and proceeded with the word "a" or "an" should be understood as not excluding plural of said elements or steps, unless such exclusion is stated. Furthermore, references to "one embodiment" or "one example" of the present disclosure are not intended to be interpreted as excluding the existence of additional embodiments that also incorporate the recited features. The terms "first," "second," and "third," etc. are used merely as labels, and are not intended to impose numerical requirements or a particular positional order on their objects. The following claims particularly point out subject matter from the above disclosure that is regarded as novel and non-obvious.

ADDITIONAL EMBODIMENTS

In a first embodiment, there is provided a boost circuit comprising: a compensation circuit configured to adjust a voltage output of the boost circuit proportionate to the voltage output of the boost circuit and inversely proportionate to a current input to the boost circuit, the compensation circuit including a first differential amplifier circuit, a battery current compensation circuit, and a boost circuit input current scaling circuit.

The first differential amplifier circuit may include a first input for the voltage output of the boost circuit, a reference voltage input, a feedback voltage input, and a current output.

The battery current compensation circuit may be a second differential amplifier circuit that includes four bipolar transistors and is directly coupled to the current output.

The battery current compensation circuit may include an output that is coupled to a power amplifier.

The boost circuit input current scaling circuit may include a shunt resistor and a third differential amplifier circuit.

**Claims**

1.  A boost circuit comprising:
    a compensation circuit configured to adjust a voltage output of the boost circuit proportionate to the voltage output of the boost circuit and inversely proportionate to a current input to the boost circuit.

2.  The boost circuit of claim 1, wherein the compensation circuit includes a differential amplifier to adjust the voltage output of the boost circuit proportionate to the voltage output of the boost circuit.

3.  The boost circuit of any of claims 1-2, wherein the compensation circuit includes a first metal oxide semiconductor field effect transistor and a first bipolar transistor coupled in parallel with a second metal oxide semiconductor field effect transistor and a second bipolar transistor.

4.  The boost circuit of any of claims 1-3, wherein the first metal oxide semiconductor field effect transistor is coupled in series to the first bipolar transistor.

5.  The boost circuit of any of claims 1-4, further comprising a third bipolar transistor and a fourth bipolar transistor.

6.  The boost circuit of any of claims 1-5, where a base of the third bipolar transistor is directly coupled to a base of the fourth bipolar transistor.

7.  The boost circuit of any of claims 1-6, further comprising a resistor, the resistor directly coupled to a collector of the third bipolar transistor, the base of the third bipolar transistor, and the base of the fourth bipolar transistor.

8.  The boost circuit of any of claims 1-7, further comprising an output of the differential amplifier that is directly coupled to an input of a battery current compensation circuit.

9.  A method for operating a boost circuit, comprising:

    generating an adjusted voltage signal via adjusting a voltage proportionate to a voltage output of the boost circuit; and
    generating the adjusted voltage signal via adjusting the voltage inversely proportionate to an input current to the boost circuit.

10. The method of claim 9, where adjusting the voltage inversely proportionate to the input current to the boost circuit includes determining the input current to the boost circuit via a shunt resistor.

11. The method of any of claims 9-10, where adjusting the voltage inversely proportionate to the input current of the boost circuit includes supplying output of a differential amplifier to a gate of a metal oxide semiconductor field effect transistor.

12. The method of any of claims 9-11, where adjusting the voltage inversely proportionate to the input current of the boost circuit includes flowing a first current through the metal oxide semiconductor field effect transistor and a first bipolar transistor.

**13.** The method of any of claims 9-12, where adjusting the voltage inversely proportionate to the input current of the boost circuit includes flowing a second current through the first bipolar transistor.

**14.** The method of any of claims 9-13, where adjusting the voltage inversely proportionate to the input current of the boost circuit includes flowing a third current through a second bipolar transistor, where the third current is proportionate to a sum of the first current and the second current, and controlling a transconductance of the differential amplifier via the third current.

**15.** The method of any of claims 9-14, where adjusting the voltage proportionate to the voltage output of the boost circuit includes generating a current via a current mirror circuit, and controlling the transconductance of the differential amplifier via the current mirror circuit.

100

110
110
110
110

108
106
104
102

FIG. 1

FIG. 2

FIG. 3

EP 4 336 727 A1

400

21db

9 db

0 db

-9 db

-21db

418
416
414
412
410
408
406
404
402

100 Hz    1 KHz    10KHz    100 KHz

FIG. 4

500

21db

9 db

0 db

-9 db

-21db

518
516
514
512
510
508
506
504
502

100 Hz    1 KHz    10KHz    100 KHz

FIG. 5

$|G_1 \ast G_2|$

804

812

810

802

FIG. 8

$|G_2|$

702

FIG. 7

604

610

602

$|G_1|$

FIG. 6

FIG. 9

FIG. 10

FIG. 11

EP 4 336 727 A1

FIG. 12B

1202

1204

FIG. 13B

1302

1304

FIG. 12A

1202

1204

FIG. 13A

1302

1304

START

1400

1402

Adjust gain of
compensation circuit
proportionate to
tracking power
supply output voltage

1404

Adjust gain of
compensation circuit
inversely
proportionate to
tracking power
supply input current

END

FIG. 14

Europäisches
Patentamt

European
Patent Office

Office européen
des brevets

# EUROPEAN SEARCH REPORT

**Application Number**

EP 23 19 0279

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | MARCO BERKHOUT ET AL: "A 4[Omega] 2.65W Class-D Audio Amplifier With Embedded DC-DC Boost Converter, Current Sensing ADC and DSP for Adaptive Speaker Protection", IEEE JOURNAL OF SOLID-STATE CIRCUITS, vol. 48, no. 12, 2 December 2013 (2013-12-02), pages 2952-2961, XP055156984, ISSN: 0018-9200, DOI: 10.1109/JSSC.2013.2284692 * page 2953, left-hand column, paragraph 1; figures 1,10 * | 1-15 | INV. H03F1/02 G05F1/575 H02M1/00 H03F3/183 H03F3/45 |
| X | BAKKER ROBERT ET AL: "Control Techniques for Audio Envelope Tracking", JAES, AES, 60 EAST 42ND STREET, ROOM 2520 NEW YORK 10165-2520, USA, 10 March 2019 (2019-03-10), XP040706576, * abstract; figures 1,5-7 * | 1-15 | |

TECHNICAL FIELDS
SEARCHED (IPC)

H03F
H02M
G05F

The present search report has been drawn up for all claims

| Place of search | Date of completion of the search | Examiner |
|---|---|---|
| The Hague | 22 January 2024 | Zakharian, Andre |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or after the filing date
D : document cited in the application
L : document cited for other reasons
...................................................................
& : member of the same patent family, corresponding document

EPO FORM 1503 03.82 (P04C01)